# EUROPEAN PATENT SPECIFICATION

(11) **EP 2 410 074 B1**
(45) Date of publication and mention of the grant of the patent: **11.12.2013**
(21) Application number: 10170223.1
(22) Date of filing: 21.07.2010
(51) Int. Cl.: C23C 14/28, C23C 14/54

(54) **Heat shield and filter**
Hitzeschild und Filter
Écran thermique et filtre

(43) Date of publication of application: 25.01.2012
(73) Proprietor: Solmates B.V., 7522 NB Enschede (NL)
(72) Inventor: Broekmaat, Joska Johannes, 7511 DS, Enschede (NL); Dekkers, Jan Matthijn, 7611 AN, Aadorp (NL); Janssens, Jan Arnoud, 7412 DL, Deventer (NL); Van Zalk, Maarten, 7531 AL, Enschede (NL)
(74) Representative: 't Jong, Bastiaan Jacob

(56) References cited:
- EP-A1- 1 683 887
- JP-A- 2003 049 262
- US-A- 5 145 713
- YOSHITAKE T ET AL: "Droplet-Free Thin Films Prepared by Pulsed Laser Deposition Using a Vane Velocity Filter" JAPANESE JOURNAL OF APPLIED PHYSICS, JAPAN SOCIETY OF APPLIED PHYSICS, JP LNKD- DOI:10.1143/JJAP.41.836, vol. 41, no. 2A PART.1, 1 February 2002 (2002-02-01), pages 836-837, XP002904273 ISSN: 0021-4922

## Description

The invention relates to a device for pulsed laser deposition according to the preamble of claim 1, as known from US 5145713.

Pulsed laser deposition (PLD)is a known technique for arranging a coating on an object. With this technique material of a target material is ablated by a laser, such that a plasma plume of this target material is generated. This plasma plume then is deposited on a substrate resulting in a coating of the target material on the substrate.

PLD was at first developed for coating small substrate surfaces, typically 10 millimeters by 10 millimeters. This is typically used in research environments, where small substrates are coated with all kinds of materials with high thin film quality.

Resulting from this research a need to coat larger surfaces originated. This has resulted in innovative techniques with which surfaces having a typical diameter of several inches or more can be coated.

In order to coat some substrate materials with PLD with the correct material properties, such as crystal structure and texture, it is often necessary to heat the substrate to temperatures of typically 200°C - 1000°C.

When a small substrate surface of about 10x10 millimeters is heated up to 200°C - 1000°C, the heat radiation does not influence too much the target material arranged opposite to the substrate material. However, as the size of the substrate surface is increased, the heat radiation is also increased resulting in an unacceptable influence on the target material. This could result in early evaporation of components of the target material, such that the deposited coating on the substrate is of another composition than the original composition of the target material.

Another problem with PLD is that there are side-products formed during the laser evaporation process. These side products or so-called particulates or droplets have a lower speed compared to the plasma especially near the target area. The speed difference between the plasma and the slow particulates relates to the process conditions. Speeds of the particulates vary from 1-300 m/sec while the plasma speed directly from the target is in the order of 500-20.000 m/sec. The plasma speed depends on the pressure in the chamber and the distance from the target. The side products are substantially originating from the target as a point-source while the plasma is more oriented in the target-substrate direction.

Particulates or so-called droplets during laser ablation are very common and will be co-deposited on the substrate as well , which influence the thin film quality of the PLD process. These particles generate all kinds of unwanted defects in the film. Especially if PLD is used to deposit large substrates and the beam is scanned the contribution of particles in and on the film increases.

JP 2003 049262 discloses a rotary body for completely preventing deposit of droplets onto a deposition film. The rotary body has a rotary shaft and a large number of flat adsorption plates. By rapid rotation of the rotary body the droplets are separated and caught by the flat adsorption plates.

It is an object of the invention to reduce the effects of the above mentioned particles or so-called droplets.

This object is achieved by the invention with a device as claimed in claim 1.

The first shield provides a shield for the major part of the substrate and the passage opening provides access for the plasma plume, which is intended for only a small part of the surface. The shield accordingly shields off some of the unwanted particles.

The first shield also protects the substrate and target from heat irradiated from the heated target material as well as heat irradiated from the heated substrate. Preferably the first shield is cooled to further protect the substrate and target from heat.

The rotating wheel provides a filter for the plasma plume. As the plasma plume has a substantial higher speed, than the undesired particles or droplets, the passage opening in the wheel can be controlled such, that the plasma plume can go from the target material through the passage opening in the first shield and through the wheel to the substrate, while the wheel can close off the passage as soon as the undesired particles or droplets arrive. These droplets will then be caught by the wheel preventing a film being formed on the substrate by the undesired particles or droplets.

In a preferred embodiment of the device according to the invention, a second shield is arranged parallel to the first shield and on the opposite side of the wheel, wherein the second shield comprises at least one passage opening, which overlaps with the at least one passage opening in the first shield.

The second shield can further reduce the heat radiation to the substrate as well as the target and can further shield off particles arriving at the substrate.

Preferably, the first shield and the second shield are connected at the circumference by a side wall. A housing is formed by both shields and the side wall, such that the rotating wheel is protected. The wheel has a typical rotation speed of 10Hz - 1000Hz, which increases safety of the PLD device.

In another embodiment of the device according to the invention the passage opening in the heat shield closest to the target mount is smaller than the passage opening in the heat shield closest to the substrate mount. The plasma plume originates as a point source from the target, such that a small passage opening is needed in the shield closest to the target mount. The surrounding particles and droplets are then already partially blocked just by a small passage opening.

In another preferred embodiment of the device according to the invention, the wheel comprises a hub with a number of vanes evenly distributed over the circumference of the hub. The space between the vanes provide passage openings for the plasma plume to pass the rotating wheel, while the lagging cloud of undesired particles is wiped away by the following vane from the wheel.

Preferably, the vanes of the wheel have a transverse cross section with a uniform thickness, such that the displacement of air by the vanes is minimized. If the cross section of a vane in the travel direction of a plasma plume, is constant, the aerodynamic lift effect is not obtained, such that the ambient air is not being propelled, which would otherwise result in undesired airflows within the PLD device, which would disturb the depositing of the plasma on the substrate. The thickness of the vanes in longitudinal direction could vary for example due to strength and stiffness requirements.

Preferably the number of vanes is a prime number. This ensures that the particles being wiped away by the vanes is evenly distributed over the prime number of vanes. Accordingly, the stability of the rotating wheel is not affected by the additional particles being deposited on the vanes.

Yet another embodiment of the device according to the invention comprises a controller for controlling the laser beam dependent on the position of the passage opening in the wheel. The controller ensures that the laser is fired at exactly the correct moment, such that the filtering action of the wheel is optimized. The passage opening in the wheel should just close of the passageway as soon as the plasma plume has passed the wheel and the cloud of droplets is still present within the passage opening in the wheel or even in front of the wheel.

These and other features of the invention will be elucidated in conjunction with the accompanying drawings.
Figure 1 shows a schematic perspective view of a first embodiment according to the invention.
Figure 2 shows a cross sectional view of a second embodiment according to the invention.
Figure 3 shows the wheel of figure 2 in perspective view.
Figure 4 shows an enlarged cross sectional view of figure 2.

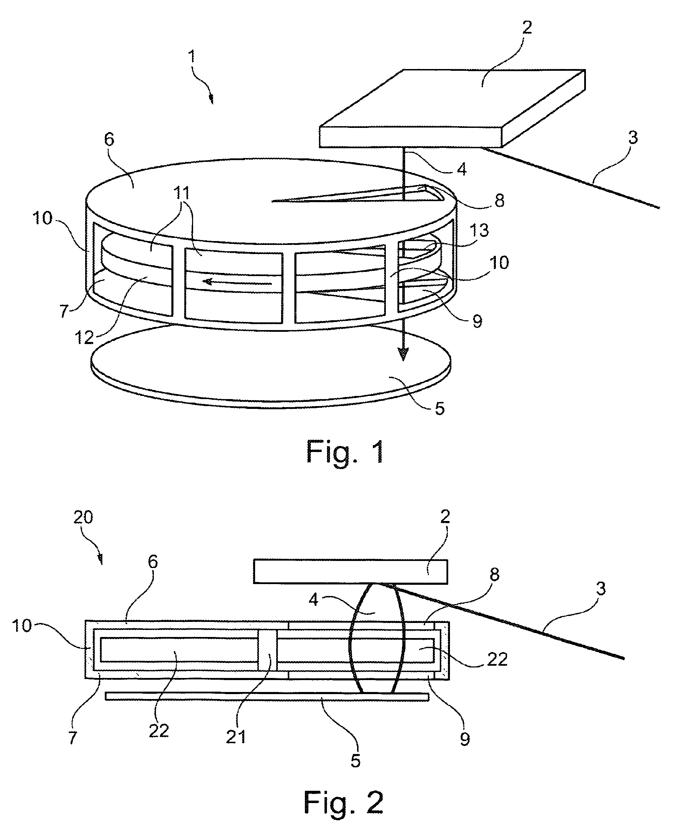

Figure 1 shows a first embodiment 1 of a device for pulsed laser deposition according to the invention. This device 1 has a target mount 2 with a target material. A laser beam 3 is directed on the surface of the target material, to generate a plasma plume 4. This plasma plume 4 is deposited on a substrate 5.

A first shield 6 and a second shield 7 are arranged between the target mount 2 and the substrate 5. The first shield 6 closest to the target mount 2 has a small passage opening 8 and the second shield 7 has a somewhat larger passage opening 9.

The first shield 6 and the second shield 7 are connected by a peripheral side wall 10, which comprises a number of openings 11. The first shield 6, second shield 7 and the peripheral side wall 10 constitute a housing for a rotating wheel 12. This rotating wheel 12 has a passage opening 13 and functions as a mechanical filter for the plasma plume 4.

Figure 2 shows a cross sectional view of a second embodiment 20. This embodiment corresponds partially with the embodiment 1 of figure 1. Similar parts are identified with the same reference signs.

The device 20 has a target mount 2 and a substrate 5. Between the target mount 2 and the substrate 5 a housing of a first shield 6 and a second shield 7 is arranged.

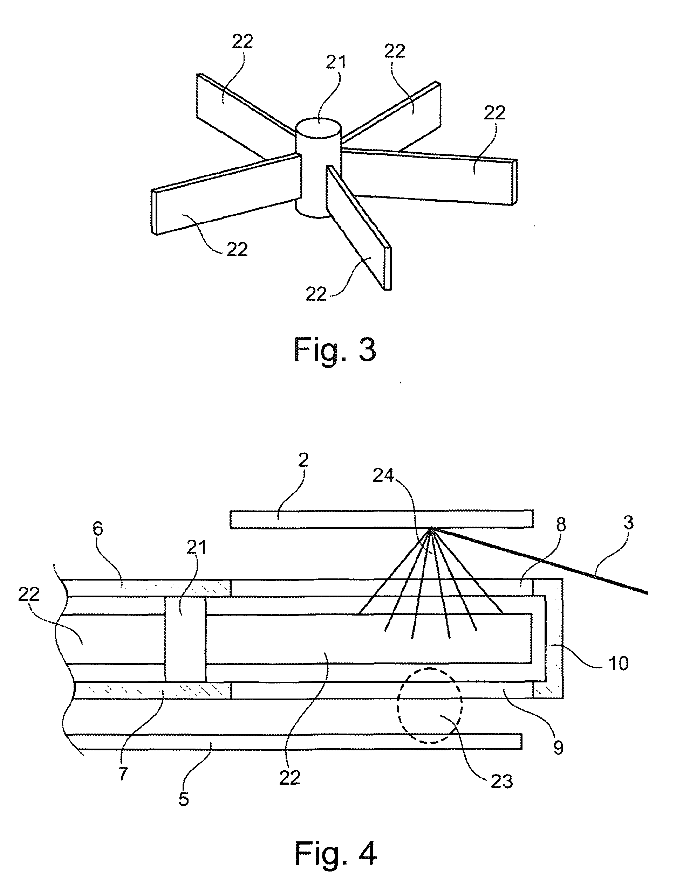

In the housing 6, 7, 10 a hub 21 with vanes 22 is arranged. This hub 21 with vanes 22 is shown in figure 3 in more detail.

From figure 2 it is clear, that the plasma plume 4 can move freely from the target material 2 through the passage opening 8, between the vanes 21 and through the passage opening 9 to the substrate 5. The vanes 21 have a constant thickness, such that no gas flow in the direction of the plasma plume 4 is generated by rotating the vanes 21. Although PLD is performed in near vacuum there will still be some gases present, which could disturb the plasma plume. By designing the vanes 22 such, that the vanes will not propel the gases, the plasma plume will at least substantially not be disturbed.

In figure 4, the filtering action of the rotating wheel 21, 22 is shown.

The laser beam 3 irradiates the target material 2, such that a plasma 23 is generated. This plasma 23 flows from the target material 2 through the passage opening 8, between the vanes 22 and through the passage opening 9 towards the substrate 5.

The plasma 23 is followed by a cloud 24 of undesired particles and droplets. By controlling the laser beam 3 depending on the position of the vanes 22, the cloud 24 can be wiped away by a vane 22, just after the plasma 23 passes the vanes 22. The cloud 24 is then deposited on one of the vanes 22 and the filtering action is performed.

## Claims

1. Device (1; 20) for pulsed laser deposition, which device comprises:
- a substrate mount with a substrate mounting surface for a substrate (5);
- a target mount (2) for a piece of target material arranged substantially parallel to and at a distance from the substrate mount;
- a laser device for directing a laser beam (3) on a piece of target material mounted on the target mount, such that a plasma plume (4; 23) of target material is generated and deposits on the substrate; and
- a first shield (6) arranged between the substrate mount and the target mount (2) for shielding the target, wherein the first shield (6) comprises at least one passage opening (8) for passage of at least the generated plasma plume (4; 23); **characterized by**:
- a rotating wheel (12) having at least one passage opening (13) extending from one side of the wheel (12) to the opposite side, wherein, seen in the direction perpendicular to shield surface (6) with the passage opening (8), the wheel (12) overlaps with the passage opening (8) in the shield (6) and the path of the passage opening (13) in the wheel (12) overlaps with the passage opening (8) in the shield (6).

2. Device (1; 20) according to claim 1, comprising a second shield (7) arranged parallel to the first shield (6) and on the opposite side of the wheel, wherein the second shield (7) comprises at least one passage opening (9), which overlaps with the at least one passage opening (8) in the first shield (6).

3. Device (1; 20) according to claim 2, wherein the first shield (6) and the second shield (7) are connected at the circumference by a side wall (10).

4. Device (1; 20) according to claim 2 or 3, wherein the passage opening (8) in the heat shield (6) closest to the target mount (2) is smaller than the passage opening (9) in the heat shield (8) closest to the substrate mount.

5. Device (20) according to any of the preceding claims, wherein the wheel (12) comprises a hub (21) with a number of vanes (22) evenly distributed over the circumference of the hub (21).

6. Device (20) according to claim 5, wherein the vanes (22) of the wheel (12) have a transverse cross section with a uniform thickness, such that the displacement of air by the vanes (22) is minimized.

7. Device (20) according claim 6, wherein the number of vanes (22) is a prime number.

8. Device (1; 20) according to any of the preceding claims, further comprising a controller for controlling the laser beam (3) dependent on the position of the passage opening (13) in the wheel (12).

## Patentansprüche

1. Vorrichtung (1; 20) für einen gepulsten Laserauftrag, wobei die Vorrichtung umfasst:
- eine Substrathalterung mit einer Substratmontagefläche für ein Substrat (5);
- eine Zielhalterung (2) für ein Stück Zielmaterial, die im Wesentlichen parallel und mit Abstand zu der Substrathalterung angeordnet ist;
- eine Laservorrichtung zum Lenken eines Laserstrahls (3) auf ein Stück Zielmaterial, das auf der Zielhalterung montiert ist, so dass ein Plasmastrahl (4; 23) aus Zielmaterial erzeugt wird und auf dem Substrat Aufträge bildet; und
- eine erste Abschirmung (6), die zwischen der Substrathalterung und der Zielhalterung (2) zum Abschirmen des Ziels angeordnet ist, wobei die erste Abschirmung (6) mindestens eine Durchgangsöffnung (8) für einen Durchgang zumindest des erzeugten Plasmastrahls (4; 23) umfasst; **gekennzeichnet durch**:
- ein drehendes Rad (12) mit mindestens einer Durchgangsöffnung (13), die sich von einer Seite des Rades (12) zur gegenüberliegenden Seite erstreckt, wobei, in die Richtung senkrecht zur Abschirmungsfläche (6) mit der Durchgangsöffnung (8) betrachtet, das Rad (12) mit der Durchgangsöffnung (8) in der Abschirmung (6) überlappt und der Pfad der Durchgangsöffnung (13) in dem Rad (12) mit der Durchgangsöffnung (8) in der Abschirmung (6) überlappt.

2. Vorrichtung (1; 20) nach Anspruch 1, eine zweite Abschirmung (7) umfassend, die parallel zur ersten Abschirmung (6) und an der gegenüberliegenden Seite des Rades angeordnet ist, wobei die zweite Abschirmung (7) mindestens eine Durchgangsöffnung (9) umfasst, die mit der mindestens einen Durchgangsöffnung (8) in der ersten Abschirmung (6) überlappt.

3. Vorrichtung (1; 20) nach Anspruch 2, wobei die erste Abschirmung (6) und die zweite Abschirmung (7) um Umfang durch eine Seitenwand (10) verbunden sind.

4. Vorrichtung (1; 20) nach Anspruch 2 oder 3, wobei die Durchgangsöffnung (8) in der Wärmeabschirmung (6), die der Zielhalterung (2) am nächsten liegt, kleiner ist als die Durchgangsöffnung (9) in der Wärmeabschirmung (8), die der Substrathalterung am nächsten liegt.

5. Vorrichtung (20) nach einem der vorangehenden Ansprüche, wobei das Rad (12) eine Nabe (21) mit einer Anzahl von Flügeln (22) umfasst, die gleichmäßig um den Umfang der Nabe (21) verteilt sind.

6. Vorrichtung (20) nach Anspruch 5, wobei die Flügel (22) des Rades (12) einen quer verlaufenden Querschnitt mit gleichförmiger dicke haben, so dass die Luftverdrängung durch die Flügel (22) minimiert ist.

7. Vorrichtung (20) nach Anspruch 6, wobei die Anzahl von Flügeln (22) eine Primzahl ist.

8. Vorrichtung (1; 20) nach einem der vorangehenden Ansprüche, des Weiteren umfassend eine Steuerung zum Steuern des Laserstrahls (3) abhängig von der Position der Durchgangsöffnung (13) im Rad (12).

## Revendications

1. Dispositif (1 ; 20) d'ablation laser pulsé, lequel dispositif comprend :
- un support de substrat avec une surface de montage de substrat pour un substrat (5) ;
- un support de cible (2) pour une pièce de matériau de cible agencé sensiblement parallèlement au support de substrat et à une distance de celui-ci ;
- un dispositif laser pour diriger un faisceau laser (3) sur une pièce de matériau de cible montée sur le support de cible, de sorte qu'un panache de plasma (4 ; 23) de matériau de cible soit généré et déposé sur le substrat ; et
- un premier bouclier (6) agencé entre le support de substrat et le support de cible (2) pour protéger la cible,
dans lequel le premier bouclier (6) comprend au moins une ouverture de passage (8) pour le passage d'au moins le panache de plasma généré (4 ; 23) ; **caractérisé par** :
- une roue rotative (12) ayant au moins une ouverture de passage (13) s'étendant d'un côté de la roue (12) au côté opposé, dans lequel, en vue dans la direction perpendiculaire à la surface de bouclier (6) avec l'ouverture de passage (8), la roue (12) chevauche l'ouverture de passage (8) dans le bouclier (6) et le chemin de l'ouverture de passage (13) dans la roue (12) chevauche l'ouverture de passage (8) dans le bouclier (6).

2. Dispositif (1 ; 20) selon la revendication 1, comprenant un deuxième bouclier (7) agencé en parallèle au premier bouclier (6) et sur le côté opposé de la roue, dans lequel le deuxième bouclier (7) comprend au moins une ouverture de passage (9), qui chevauche l'au moins une ouverture de passage (8) dans le premier bouclier (6).

3. Dispositif (1 ; 20) selon la revendication 2, dans lequel le premier bouclier (6) et le deuxième bouclier (7) sont reliés à la circonférence par une paroi latérale (10).

4. Dispositif (1 ; 20) selon la revendication 2 ou 3, dans lequel l'ouverture de passage (8) dans le bouclier thermique (6) le plus proche du support de cible (2) est plus petite que l'ouverture de passage (9) dans le bouclier thermique (8) le plus proche du support de substrat.

5. Dispositif (20) selon l'une quelconque des revendications précédentes, dans lequel la roue (12) comprend un moyeu (21) avec un nombre d'ailettes (22) réparties uniformément sur la circonférence du moyeu (21).

6. Dispositif (20) selon la revendication 5, dans lequel les ailettes (22) de la roue (12) ont une coupe transversale d'une épaisseur uniforme, de sorte que le déplacement de l'air par les ailettes (22) soit minimisé.

7. Dispositif (20) selon la revendication 6, dans lequel le nombre d'ailettes (22) est un nombre premier.

8. Dispositif (1 ; 20) selon l'une quelconque des revendications précédentes, comprenant en outre un organe de commande pour commander le faisceau laser (3) en fonction de la position de l'ouverture de passage (13) dans la roue (12).
